# EUROPEAN PATENT SPECIFICATION

(11) **EP 4 254 799 B1**
(45) Date of publication and mention of the grant of the patent: **02.12.2026**
(21) Application number: 22166294.3
(22) Date of filing: 01.04.2022
(51) Int. Cl.: H03K 17/18, H03K 17/08

(54) **FAULT PROTECTION IN SWITCH DRIVER UNITS**
FEHLERSCHUTZ IN SCHALTERTREIBEREINHEITEN
PROTECTION CONTRE LES PANNES DANS LES UNITÉS DE COMMANDE DE COMMUTATEUR

(43) Date of publication of application: 04.10.2023
(73) Proprietor: Power Integrations, Inc., San Jose, CA 95138 (US)
(72) Inventor: Volke, Andreas, 59494 Soest (DE); Dustert, Christoph, 59494 Soest (DE); Fink, Karsten, 59457 Werl (DE); Hornkamp, Michael, 59469 Ense (DE)
(74) Representative: Fish & Richardson P.C.

(56) References cited:
- US-A1- 2017 134 018
- US-A1- 2019 326 897

## Description

### TECHNICAL FIELD

This document relates to protecting against faults in driver units for transistors and other switches, for example, driver units that can implement a switching scheme for an inverter.

### BACKGROUND

In some contexts, the switching of multiple switches-and the operation of the driver units that drive the switches- is coordinated to achieve a particular objective. One example of such a context is in inverters. Inverters convert a battery or other dc input into an ac signal. The ac signal can be suitable, e.g., for driving an electric motor of an electric vehicle. There are many different types of inverters and different circuit topologies and control schemes can be used. A common inverter includes three phase legs. Each phase leg includes a pair of power switches coupled in a half-bridge configuration between a high voltage rail and a low voltage rail with an intermediate output node (also called a phase output, a switch node, or an LX node) between them. The switching of the switches in the different phase legs is coordinated to generate desired waveforms on the output nodes.

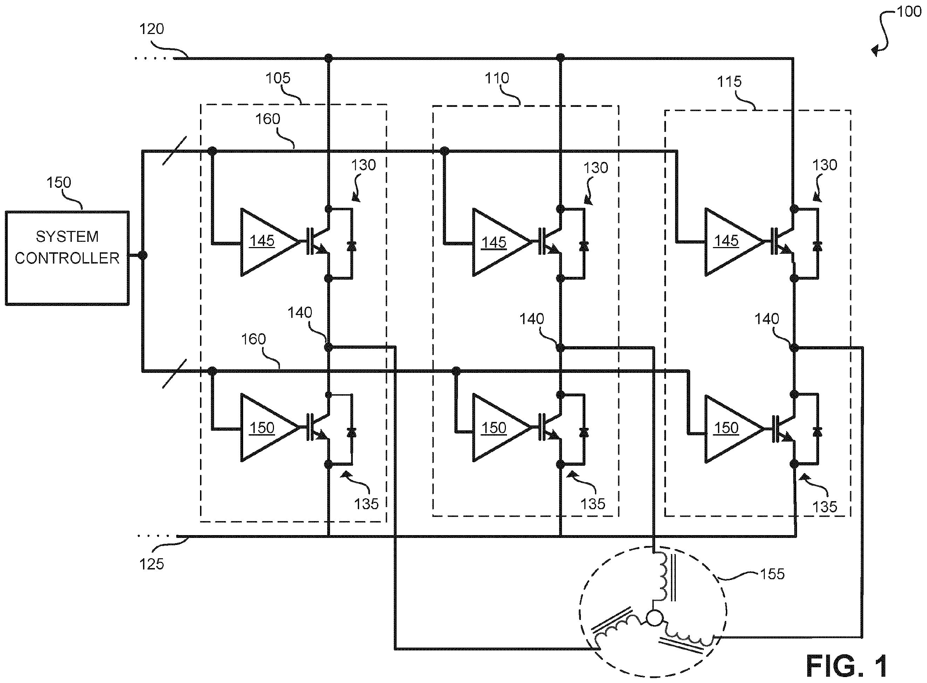

FIG. 1 is a schematic representation of an inverter 100 that includes three phase legs 105, 110, 115 coupled between a high voltage rail 120 and a low voltage rail 125. Each phase leg 105, 110, 115 includes a respective high side power switch 130, a low side power switch 135, an output node 140, a high side driver unit 145, and a low side driver unit 150. Each high side driver unit 145 drives a respective high side power switch 130. Each low side driver unit 145 drives a respective low side power switch 135.

Although power switches 130, 135 are illustrated as insulated gate bipolar transistors (IGBTs) and their terminals are described with corresponding (gate, emitter, collector) terminology, power switches 130, 135-and indeed, all of the power switches described herein-can also be implemented as metal-oxide field-effect transistors (MOSFETs) or bipolar junction transistors (BJTs). Further, the power switches can be implemented using gallium nitride (GaN), silicon (Si), or silicon carbide (SiC) semiconductors. Also, although gate driver units 145, 150 are drawn as triangular-shaped blocks, driver units 145, 150 generally include some level of both communication and control circuitry- in addition to the drive circuitry that biases the control terminal of a respective power switch 130, 135. In some implementations, driver unites 145, 150 may also include fault detection circuitry to detect fault conditions of power switches 130, 135 (e.g., short-circuit or over-current faults).

The switching of switches 130, 135 in phase legs 105, 110, 115 is coordinated by a system controller 150 in accordance with a drive scheme. Due to this coordination, gate driver units 145, 150 form a network that achieves a desired driving of a load 155. The particular details of the drive scheme will depend on the desired driving and load 155. In the illustrated implementation, load 155 is illustrated as a three phase induction motor. However, load 155 can be any of a number of different loads and a variety of different drive schemes can be used.

System controller 150 communicates with gate driver units 145, 150 using gate driver bus 160. Although only a single line is drawn in the schematic representation of inverter 100, this single line generally represents a bus with multiple wires or other communication channels--as represented by the slanted lines across bus 160. For example, system controller 150 and gate driver units 145, 150 may coordinate the switching of switches 130, 135 using a separate communication channel on bus 160 for each pair of gate driver units 145, 150, a pair of communication channels for each pair of gate driver units 145, 150, or a pair of communication channels for each individual gate driver unit 145, 150 (i.e., four gate driver channels per each phase leg 105, 110, 115). As another example, system controller 150 and gate driver units 145, 150 may communicate using one or more communication channels that convey, e.g., status and/or fault detection information-either or both from system controller 150 to gate driver units 145, 150 and from gate driver units 145, 150 to system controller 150. Thus, communication between system controller 150 and gate driver units 145, 150 is not limited to coordination of switching.

US 2019/0326897 A1 describes a driving device for a semiconductor element which includes: a plurality of detection circuits that detect different types of abnormalities of the semiconductor element; a logic circuit that generates an error signal when at least one of the detection circuits detects an abnormality; an alarm signal generating circuit that receives the error signal and generates an alarm signal made of one or a plurality of pulses, the alarm signal having a different pulse width for each of the detection circuits that has detected an abnormality; and a protection operation determining circuit that determines whether or not a protection function of the semiconductor element is operating based on the error signal and the alarm signal, and shuts off input of a drive signal to the semiconductor element when it is determined that the protection function is operating.

US 2017/0134018 A1 describes a drive device to drive a semiconductor element which includes: an identification signal generating circuit generating an identification signal depending on a type of an input error signal; a protection operation signal generating circuit generating a protection operation signal having a pulse width equal to that of one of the error signal and the identification signal having a longer pulse width; an identification signal terminal inputting and outputting the identification signal; a protection operation signal terminal inputting and outputting the protection operation signal; and a protection circuit performing an error protection operation depending on an own-phase protection operation signal generated by the protection operation signal generating circuit and an other-phase protection operation signal input through the protection operation signal terminal.

### DESCRIPTION OF DRAWINGS

Non-limiting and non-exhaustive embodiments of the present invention are described with reference to the following figures, wherein like reference numerals refer to like parts throughout the various views unless otherwise specified.
FIG. 1 is a schematic representation of an inverter that includes three phase legs.
FIG. 2 is a schematic representation of an example gate driver unit.
FIG. 3 is a schematic representation of an implementation of a gate driver unit.
FIG. 4 is a schematic representation of an inverter that includes three phase legs.

Like reference symbols in the various drawings indicate like elements.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention.

### DETAILED DESCRIPTION

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

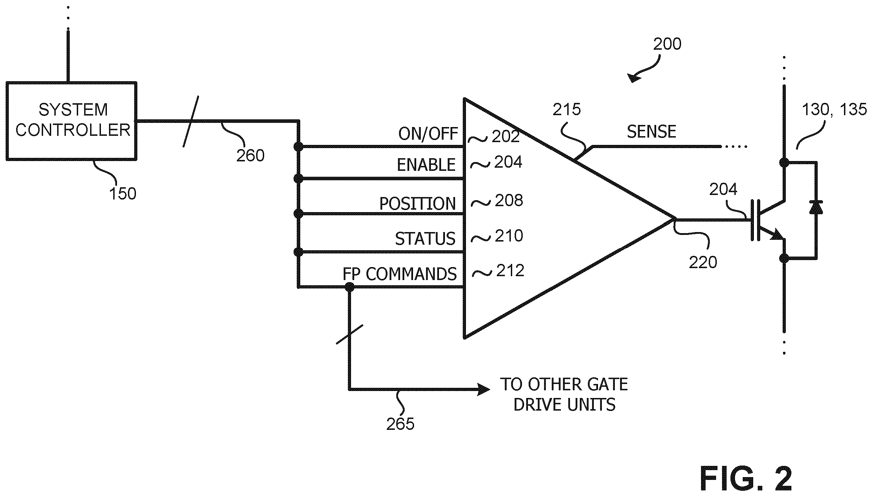

FIG. 2 is a schematic representation of an example gate driver unit 200. Gate driver unit 200 can be configured to drive power switches, e.g., high and low side power switches 130, 135 in an inverter such as inverter 100 (FIG. 1). However, in addition to the functionality attributed to gate driver unit 145, 150, gate driver unit 200 can also communicate with other gate driver units to convey, e.g., fault protection information. At least some portion of this communication is not mediated by a system controller such as system controller 150. Rather, one gate driver unit 200 can convey information to another gate driver unit 200, thus speeding communications and decreasing the time needed for one gate driver unit 200 to respond to conditions at another gate driver unit.

In more detail, the illustrated implementation of gate driver unit 200 includes terminals 202, 204, 206, 208, 210, 212, a sense input 215, and a drive signal output 220. Sense input 215 is configured to input one or more signals that include information characterizing the operation of the power switch 130, 135 driven by gate driver unit 200. The received information can suffice for gate driver unit 200 to determine a fault condition in the driven power switch 130, 135. The information can characterize, e.g., current flow through the driven power switch, the voltage at one or more terminals of the driven power switch, and/or the temperature of the power switch. In one example, sense input 215 may be implemented using multiple physical terminals that are each dedicated to receiving a different signal. In another example, a single terminal may be used for sense input 215 to sense multiple characteristics of the power switch 130,135, such as the current flow or the voltage at one terminal of the power switch 130, 135. Further, multiplexing and other channel division schemes could also be used to receive different signals over a single terminal.

Drive signal output 220 outputs the drive signal that is coupled to the gate terminal of the driven power switch 130, 135. The particular characteristics of the drive signal will depend on the nature of the driven power switch 130, 135. Further, the drive signal will generally be conditioned to achieve a certain switching profile including, e.g., switching speed, level of dv/dt withstand immunity, and the like. In some implementations, a gate resistance and/or other components are coupled between the drive signal output 220 and the gate terminal of the driven power switch 130, 135.

Terminals 202, 204, 206, 208, 210, 212 are all configured to be coupled to wires in bus 260 to exchange information and/or commands with system controller 150. As discussed below, at least one of terminals 202, 204, 206, 208, 210, 212 can also be coupled to a bus 265 that establishes at least one communication channel that allows different gate driver units to exchange information and/or commands with each other, i.e., without mediation by system controller 150. Although bus 265 is illustrated as a single wire bus, bus 265 can also be implemented using multiple wires and/or communication channels.

The particular details about the information and/or commands communicated over terminals 202, 204, 206, 208, 210, 212 can vary in different implementations of different gate driver units. However, in the illustrated gate driver unit 200, terminal 202 can be an input terminal that is configured to receive commands that specify the times at which the power switch driven by gate driver unit 200 is to be driven ON and OFF. The timing commands can be received from a system controller such as system controller 150. The commands received by terminal 202 can convey timing information in a variety of different ways. For example, a pulse train with logic high and logic low sections can convey when the power switch is to be driven ON and OFF. For example, the logic high sections can convey when the power switch is to be driven ON and the logic low sections can convey when the power switch is to be driven OFF.

Although terminal 202 is illustrated as a single terminal that is connected to a single wire of bus 260, terminal 202 can also be implemented as a pair of terminals that are connected to different wires. For example, one terminal of the pair can be configured to receive commands that specify the times at which the power switch driven is to be driven ON by gate driver unit 200. The other can be configured to receive commands that specify the times at which the same power switch driven is to be driven OFF by gate driver unit 200. As another example, one terminal of the pair can be configured to receive commands that specify the times at which the power switch driven by gate driver unit 200 is to be driven ON and OFF. The other of the pair can be configured to receive commands that specify the times at which a different gate driver unit is to drive a different power switch ON and OFF. For example, if gate driver unit 200 is coupled to drive a high side switch, the different gate driver unit can be coupled to drive a low side switch in the same inverter phase leg. The ON/OFF timing commands for both gate driver units in a phase leg can be used by gate driver units such as gate driver unit 200 to ensure that an inadvertent short across the phase leg is avoided.

Returning to the illustrated gate driver unit 200, terminal 204 can be an input terminal that is configured to receive commands that enable (essentially, "turn on") or disable (essentially, "turn off") gate driver unit 200. The commands can be received from a system controller such as system controller 150. In one example, if terminal 204 is set low, the gate driver unit 200 ignores signals received on terminal 202 to turn ON and turn OFF the power switch. If terminal 204 is set to high, the gate driver unit 200 responds to signals received on terminal 202.

Terminal 208 can be an input terminal that is configured to receive information that characterizes the position of gate driver unit 200 in a network of gate driver units. For example, the position information can be embodied in a signal received from a system controller such as system controller 150. As another example, not covered by the present invention, the position information can be deduced from the nature of components that are coupled to terminal 208. For example, a pull-down or pull-up resistor may be coupled to terminal 208 and either a return (e.g. GND) or a voltage supply (e.g. VCC) to hard-code the position of the gate driver unit 200 in the network of gate driver units. In this case, terminal 208 is not coupled to the system controller.

The position information received at terminal 208 suffices to specify the role of gate driver unit 200 in the network of gate driver units so that gate driver unit 200 can respond appropriately in the event of a fault condition in the network. By way of example, referring back to inverter 100 (FIG. 1), the operations of the six driver units 145, 150 form a network and the switching of power switches 130, 135 must be coordinated to perform a task, namely, driving three phase induction motor 155. In this context, the position information can specify whether gate driver unit 200 is positioned as a high-side gate driver unit 145 or a low-side gate driver unit 150. In other contexts in which the operations of gate driver units are coordinated to perform other tasks with other coordination schemes, different position information can be received.

In any case, as discussed further below, the received position information can contribute to the fault protection functionality provided by gate driver unit 200.

Terminal 210 can be a bidirectional input/output terminal that is configured to transmit and receive status information that characterizes the operational status of a device or system in which gate driver unit 200 is active, as well as the operational status of gate driver unit 200 or the power switch 130, 135 driven thereby. The exchange of status information is generally mediated by a system controller such as system controller 150. For example, if gate driver unit 200 were to transmit status information over terminal 210, system controller 150 could receive the status information and relay the received status information to other gate driver units using the same channel in bus 260.

As discussed below, the status information conveyed over terminal 210 can be used by gate driver unit to interpret fault protection commands. In some implementations, the status information can characterize the fault at a relatively high level of abstraction. For example, rather than specifying the precise nature of the fault, the gate driver unit that detects a fault can transmit status information indicating a classification of the fault. The classification can contribute to the interpretation of fault protection commands for determining an appropriate response. In some implementations, position information received over terminal 208 can also contribute to the interpretation of fault protection commands for determining an appropriate response. In such cases, even though the other gate drive units are not provided extensive details regarding the nature of any particular fault, they can still respond appropriately based on the processing done by the transmitting gate driver unit to classify the fault.

In any case, the particular status information conveyed over terminal 210 will depend on the operational context of gate driver unit 200. For example, in one implementation in which gate driver unit 200 is operating within an inverter, the status information can characterize whether a fault has been detected within the inverter.

In other implementations, the status information can provide additional details regarding the nature of the fault. For example, in the context of an inverter, the status information can identify the fault as:
- an undervoltage lock-out condition is present on the primary side of a power converter that supplies the power used by gate driver unit 200 to drive power switch 130, 135,
- an undervoltage lock-out condition is present on the secondary side of a power converter that supplies the power used by gate driver unit 200 to drive power switch 130, 135,
- a phase short circuit present in the inverter,
- a short circuit present across the switch 130, 135,
- an over temperature detection of the gate driver unit 200,
- a watchdog time-out within the gate driver unit 200,
- a detection of communication failures within the gate driver unit 200,
- a failure of either the power switch driven by gate driver unit 200 or a power switch elsewhere in a network of power switches to turn on, or
- a fault indicated by an external device.

Other faults and/or information may be identified by the status information.

Terminal 212 can be a bidirectional input/output terminal that is configured to transmit and receive fault protection commands. In the illustrated implementation, terminal 212 is coupled both to a channel in bus 260 and to at least one channel in bus 265 that can convey information to corresponding terminals on other gate drive units. Bus 260 and the channel in bus 265 can be physically implemented in a variety of different ways. For example, buses 260, 265 can be formed using multiple insulated wires housed in a single insulating sheath. As another example, buses 260, 265 can be formed using separate insulated wires that are loose or tied together, e.g., using a cable tie. As another example, buses 260, 265 can be formed by multiplexing or otherwise dividing wires into multiple communication channels. In any case, gate driver units can communicate with one another over bus 265 without mediation by system controller 150.

The fault protection commands on buses 260, 265 can originate from individual gate driver units in a network-including gate driver unit 200. In some implementations, the fault protection commands may also originate from system controller 150. However, when the gate driver units can communicate with one another without mediation by system controller 150, the network of gate driver units can respond to fault conditions relatively more quickly. The fault protection functionality that is present in the individual gate driver units for monitoring the operation of the power switch that it drives can be leveraged. Indeed, in the event that system controller 150 itself suffers a fault, a more serious failure can be avoided.

As discussed above, proper interpretation of the fault protection commands received over terminal 212 can be based on other information and/or commands received by gate driver unit 200. For example, the fault protection commands received over terminal 212 can be expressed at a relatively high level of abstraction, e.g., using logic high/logic low states.

In the example below, the commands expressed in the logic high/logic low states correspond to the location of the fault within an inverter, e.g., whether the fault has occurred on the high side or the low side. In such cases, the proper response of a gate driver unit is determined based on other, related information. For example, the proper response of a gate driver unit to these states can depend on the position of the gate driver in an inverter-as indicated by the position information received at terminal 208. As yet another example, the proper response of a gate driver unit to the fault protection commands received over terminal 212 can depend on whether a fault is present or even specific characteristics of the fault-as indicated by the status information conveyed over terminal 210.

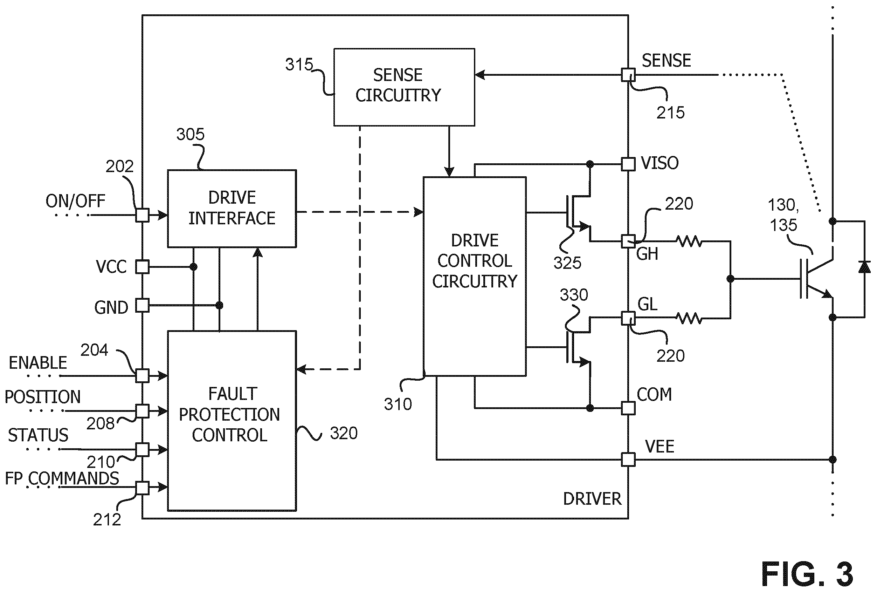

FIG. 3 is a schematic representation of an implementation of a gate driver unit 300. Gate driver unit 300 is one possible implementation of gate driver unit 200 (FIG. 2) and features that are shared have been denoted with the same reference numerals.

Gate driver unit 300 includes a drive interface 305, drive control circuitry 310, sense circuitry 315, and a fault protection control 320. Drive interface 305 is a communications interface that converts the timing commands received at terminal 202 into commands that are appropriate for drive control circuitry 310. In general, drive interface 305 is galvanically isolated from drive control circuitry 310. Circuitry coupled to the primary-side of the galvanic isolation receive operating power from terminals VCC and GND. Circuitry coupled to the secondary-side of the galvanic isolation receive operating power from terminals VISO and COM. The dashed line between the drive interface 305 and drive control circuitry 310 indicates the galvanic isolation and that information can be communicated-- even across galvanic isolation. For example, drive interface 305 may transmit timing commands to drive control circuitry 310 using, e.g., optical components, a communications transformer, magnetically-coupled indictors, capacitively-coupled components, or the like. The details of the conversion performed by drive interface 305 can depend upon, e.g., the nature of the drive control circuitry 310, the signals received at terminal 202, and whether and how drive interface 305 is galvanically isolated from drive control circuitry 310.

The conversion performed by drive interface 305 is also based on input from fault protection control 320. As discussed further below, fault protection control 320 may recognize and categorize a short circuit fault in the power switch driven by gate driver unit 300 or be informed about a short circuit fault in another power switch driven that is driven by a different gate driver unit. Fault protection control 320 is configured to instruct drive interface 305 (or, in some implementations, drive control circuitry 310) to tailor the driving of power switch 130, 135 based on such faults. For example, fault protection control 320 may be configured to instruct drive interface 305 or drive control circuitry 310 to hold power switch 130, 135 open or closed-regardless of the timing commands received at terminal 202.

Drive control circuitry 310 is responsible for generating a drive signal for the power switch 130, 135 driven by gate driver unit 300. Drive control circuitry 310 generates the drive signal in accordance with the commands received from drive interface 305 and any tailoring received from fault protection control 320. For example, in the illustrated implementation, drive control circuitry 310 biases a pull-up transistor 325 and a pull-down transistor 330 to couple and decouple appropriate voltages with the control terminal of the driven power switch 130, 135. In some implementations, the drive signal for the driven power switch 130, 135 can be shaped, e.g., to achieve a specific turn-on profile, to avoid harm to the driven power switch 130, 135, to respond to operational conditions, or to achieve other objectives. For example, the drive signal for the driven power switch 130, 135 can be controlled based on measured values or a feedback signal received from sense circuitry 315.

Sense circuitry 315 is coupled to the driven power switch 130, 135 and configured to sense one or more parameters that characterize the state of the driven switch. At least some of the sensed parameters are appropriate for identifying one or more fault conditions in the switching of the switch. Measured values or other information about the parameters is communicated to fault protection control 320. In general, sense circuitry 315 is galvanically isolated from fault protection control 320 and the dashed line between the sense circuitry 315 and fault protection control 320 indicates that information can be communicated-- even across galvanic isolation. In some implementations, sense circuitry 315 communicates information about the sensed parameters of the drive switch 130, 134 to the drive interface 305 using the same galvanically-isolated communication channel(s) used to transmit timing commands from drive interface 305 to drive control circuitry 310. Drive interface 305 may then send the sensed parameters to the fault protection control 320.

As for the sensed parameter(s), sense circuitry 315 can be configured to sense the main current through power switch 130, 135, one or more voltages at a node of power switch 130, 135, or both the current and voltage(s). In some implementations, sense circuitry 315 may also sense the temperature of power switch 130, 135. For example, a short circuit or failure to turn on can be identified from either the magnitude and/or the waveform of the main current through the driven power switch. As another example, a short circuit or failure to turn on can be identified from the voltage drop across the main terminals of the driven power switch. As discussed above, in some implementations, sense circuitry 315 can provide measured values or a feedback signal to drive control circuitry 310.

Fault protection control 320 is circuitry that is configured to implement fault protection functionality within gate driver unit 300. Fault protection functionality is a group of operations performed by the gate driver unit 300 to recognize and respond to fault conditions. The fault conditions can be present in gate driver unit 300 or in another gate driver unit in a network of gate driver units. The fault condition can be present in the power switch driven by gate driver unit 300 or in another power switch that is driven by another gate driver unit in a network of gate driver units. In some instances, the fault condition can be present in both a gate driver unit and a power switch.

Fault protection functionality typically enables each gate driver unit to monitor the operation of the power switch that it drives to recognize and characterize short circuits. For example, gate driver unit 300 may compare the voltage across power switch 130, 135 and/or the current that flows between the main terminals of power switch 130, 135 with each other and/or with threshold levels or waveforms to recognize a short circuit condition or if power switch 130, 135 does not turn on. As another example, gate driver unit 300 may monitor the temperature of the driven power switch.

Further, fault protection functionality enables each gate driver unit to:
- transmit information regarding faults in the driving of a respective driven power switch, and
- appropriately respond to information received from other gate driver units regarding faults in the driving of the power switches that they drive. The information can be exchanged between gate driver units without mediation, e.g., by a system controller 150 (FIG. 1). Rather, information and/or commands can be exchanged between the gate driver units themselves.

Fault protection control 320 is coupled to terminal 204 to receive enable/disable commands, terminal 206 to receive reset commands, terminal 208 to receive position information, terminal 210 to transmit and receive status information, and terminal 212 to transmit and receive fault protection commands. As discussed above, terminal 212 is coupled to both buses 260, 265 and fault protection commands can be exchanged on bus 265 between gate driver units - including gate driver unit 300-without mediation by system controller 150.

The fault protection functionality implemented by fault protection circuit control 320 can depend on the operational context of gate driver unit 300. An example operational context is in an inverter, e.g., inverter 100 (FIG. 1). In such a context, the fault protection functionality can cause gate driver unit 300 to responds differently in the event of a low-side short circuit or a high-side short circuit. Examples of fault types and the response implemented by fault protection circuit functionality in an inverter are shown in Table 1. In Table 1, "UVLO" denotes an undervoltage lockout condition on either the primary or the secondary side of a power converter that provides the power for driving a power switch. In the context of gate driver unit 300 (FIG. 3), an undervoltage lockout condition occurs on the secondary side when the voltage across the terminals labeled "VISO" and "COM" falls below a threshold. An undervoltage lockout condition occurs on the primary side when the voltage across the terminals labeled "VCC" and "GND" falls below a threshold.

**Table 1. Example fault types and responses.**

| **FAULT** | | **FAULT PROTECTION CIRCUIT RESPONSE** | |
|---|---|---|---|
| **TYPE** | **POSITION** | **HIGH SIDE SWITCHES** | **LOW SIDE SWITCHES** |
| Primary UVLO | High Side | ALL OFF | ALL ON |
| Primary UVLO | Low Side | ALL ON | ALL OFF |
| Secondary UVLO | High Side | ALL OFF | ALL ON |
| Secondary UVLO | Low Side | ALL ON | ALL OFF |
| Phase Short | High Side | ALL OFF | ALL ON |
| Phase Short | Low Side | ALL ON | ALL OFF |
| Failure to Switch | High Side | ALL OFF | ALL ON |
| Failure to Switch | Low Side | ALL ON | ALL OFF |
| Collector-Emitter Short | High Side | Phase Short detected by related Low Side Switch | |
| Collector-Emitter Short | Low Side | Phase Short detected by related High Side Switch | |

The commands and/or information regarding the type and location of faults that are exchanged between gate driver units on bus 265 can be encoded using a variety of different schemes. Encoding schemes that use binary states (e.g., logic high/logic low) can be relatively robust in operational contexts where relatively large voltages are switched including, e.g., inverters.

In some implementations, commands that enable and disable a gate driver unit can be encoded as logic high/logic low states. Position information specifying that a gate driver unit is positioned on the high-side or low side can be encoded as logic high/logic low states. Status information specifying that a fault has been detected or has not been detected somewhere in the device in which gate driver unit is operating can be encoded as logic high/logic low states. Fault protection circuit commands specifying that the detected fault is on the high side of an inverter or on the low side of an inverter can be encoded as logic high/logic low states.

Table 2 and Table 3 present example implementations of fault protection circuit functionality using a binary encoding scheme. The binary information (yes/no, low/high, fault/no fault) can be encoded using logic high/logic low states in any desired manner. Table 2 describes an implementation of fault protection circuit functionality in a high-side gate driver unit, whereas Table 3 describes a corresponding implementation in a low-side gate driver unit.

**Table 2. Fault protection functionality for a high-side gate driver unit.**

| **ENABLE** | **STATUS** | **POSITION** | **FP COMMAND** | **RESPONSE** |
|---|---|---|---|---|
| NO | XX | HIGH | XX | OFF |
| YES | NO FAULT | HIGH | XX | DRIVING |
| YES | FAULT | HIGH | LOW | OFF |
| YES | FAULT | HIGH | HIGH | ON |

**Table 3. Fault protection functionality for a low-side gate driver unit.**

| **ENABLE** | **STATUS** | **POSITION** | **FP COMMAND** | **RESPONSE** |
|---|---|---|---|---|
| NO | XX | LOW | XX | OFF |
| YES | NO FAULT | LOW | XX | DRIVING |
| YES | FAULT | LOW | LOW | ON |
| YES | FAULT | LOW | HIGH | OFF |

As shown, in the example implementations of Table 2 and Table 3, the type and location of detected faults (e.g., UVLO, phase short, failure to switch, collector-to-emitter short) have been abstracted and classified into two categories, namely, whether the fault is on the high side of an inverter or on the low side. The fault protection circuit commands encode this classification as logic high or logic low. The proper response of a gate drive unit to the commands depends on the position of the gate drive unit in the inverter.

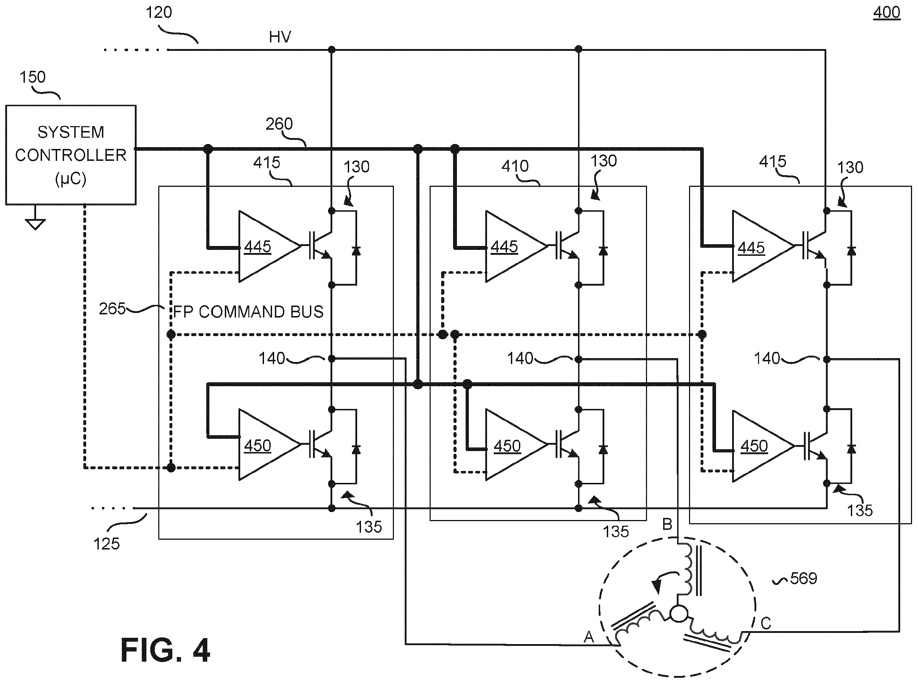

FIG. 4 is a schematic representation of an inverter 400 that includes three phase legs 405, 410, 415 coupled between a high voltage rail 420 and a low voltage rail 425. Each phase leg 405, 410, 415 includes a respective high side power switch 130, a low side power switch 135, an output node 140, high side gate driver unit 445, and low side gate driver unit 450. These gate driver units 445, 450 are each implemented as gate driver units 200 (FIGS. 2, 3). The high and low side gate driver units 445, 450 can communicate fault protection information with each other without mediation by system controller 150. This speeds communications and decreases the time needed for one gate driver unit 445, 450 to respond to conditions at another gate driver unit.

Each gate driver unit 445, 450 includes terminal 212 that is configured to transmit and receive fault protection commands over bus 265 (shown in dashed lines). Bus 265 is illustrated separately from bus 160 to emphasize that communications over bus 265 are not mediated by system controller 150. Rather, a fault protection command that is transmitted over bus 265 by one gate driver unit 200 can be received, interpreted, and acted upon by other gate driver units 200. As discussed below, fault protection commands can be communicated to the system controller 150 through bus 265, thereby keeping the system controller 150 appraised of the fault protection commands being sent by gate drivers 445, 450.

In the illustrated implementation, bus 265 is shown as a single wire that is physically separate from the other wires in bus 260. Further, system controller 150 is shown coupled to bus 265 separately from the coupling to bus 260. This is not necessarily the case. As discussed above, buses 260, 265 can be physically implemented in a variety of different ways and using division schemes, if needed. For example, the wires of bus 265 can be housed separately or in the same sheath as the wires of bus 260. Regardless of the physical implementation, information can be conveyed between gate driver units 200 without mediation by system controller 150.

Further, in general, system controller 150 can also communicate on bus 265. For example, system controller 150 can also include a bidirectional input/output terminal that is configured to transmit and receive fault protection commands. In such implementations, system controller 150 can communicate, e.g., fault protection commands that are received from external devices, for example, from other system controllers. In some case, primary and second UVLO commands may also be put on bus 265 by system controller 150.

The above description of illustrated examples of the present invention, including what is described in the Abstract, are not intended to be exhaustive or to be limitation to the precise forms disclosed. Indeed, it is appreciated that the specific example voltages, currents, frequencies, power range values, times, etc., are provided for explanation purposes and that other values may also be employed in other embodiments and examples in accordance with the teachings of the present invention. The scope of the present invention is defined by the appended claims.

## Claims

1. A device comprising:
a plurality of switches (130);
a plurality of driver units (200, 445, 450), wherein each driver unit is coupled to drive a respective switch of the plurality of switches;
a system controller (150) coupled to each of the driver units by a bus (160), wherein the system controller is configured to coordinate driving of the respective switches by the driver units to form a network of the driver units that achieves a desired driving of a load, wherein the system controller is configured to communicate a position of each of the driver units in the network of the driver units to each of the driver units over the bus; and
a communication channel (265) coupled to each of the driver units, wherein the driver units are configured to communicate with each other over the communication channel without mediation by the system controller and each of the driver units is configured to interpret fault protection commands based on the communicated position.

2. The device of claim 1, wherein each of the driver units is configured to characterize a fault in the driving of its respective switch and output a characterization of the fault over the communication channel.

3. The device of claim 2, wherein each of the driver units is configured to respond to corresponding characterizations of faults in the driving of others of the plurality of switches, wherein the corresponding characterizations are received over the communication channel.

4. The device of claim 2 or claim 3, wherein the device is an inverter and the output characterizations of the fault include an undervoltage lockout condition on a primary side of a power converter and an undervoltage lockout condition on a secondary side of a power converter.

5. The device of claim 1, wherein the system controller (150) is configured to communicate a status of the device to each of the driver units over the bus.

6. The device of claim 6, wherein each the driver units is configured to interpret the fault protection commands based on the communicated status of the device.

7. The device of claim 1, wherein the system controller is further coupled to the communication channel.

8. The device of claim 1, wherein the communication channel is implemented in at least one wire of a second bus.

9. The device of claim 1, wherein the device comprises an inverter (400).

10. The device of any preceding claim, wherein the position information specifies that a gate driver unit is positioned on a high-side or a low side in an inverter.

11. The device of any preceding claim, wherein each of the driver units (200, 445, 450) is suitable for driving a transistor and comprises:
a communications interface configured to receive timing information from the system controller (150) indicating when the transistor (130, 135) driven by the driver unit is to be switched;
a first terminal (202) and a second terminal (208) both configured to be coupled to the system controller (150), wherein the first terminal is configured to receive the timing information and the second terminal is configured to receive position information characterizing the position of the driver unit in the network of driver units;
sense circuitry (315) configured to sense one or more characteristics of a state of the transistor driven by the driver unit; and
fault protection control circuitry (320) coupled to the sense circuitry and, based on the one or more characteristics of the state of the driven transistor, configured to categorize a fault in a driving of the driven transistor, wherein the fault protection control circuitry is coupled to output a categorization of the fault from the driver unit and wherein the fault protection control circuitry is further configured to interpret and respond to corresponding categorizations of faults in driving of other transistors by other driver units based on the communicated position information.

12. The driver unit of claim 11, wherein the fault protection control circuitry is coupled to output the categorization of the fault from the driver unit via a terminal (212) and to receive the corresponding categorizations via the same terminal (212).

## Patentansprüche

1. Vorrichtung, umfassend:
eine Vielzahl von Schaltern (130);
eine Vielzahl Treibereinheiten (200, 445, 450), wobei jede Treibereinheit dazu gekoppelt ist, einen jeweiligen Schalter der Vielzahl von Schaltern anzusteuern;
eine Systemsteuerung (150), die mit jeder der Treibereinheiten durch einen Bus (160) gekoppelt ist, wobei die Systemsteuerung dazu konfiguriert ist, die Ansteuerung der jeweiligen Schalter durch die Treibereinheiten zu koordinieren, um ein Netzwerk der Treibereinheiten zu bilden, das eine gewünschte Ansteuerung einer Last erreicht, wobei die Systemsteuerung dazu konfiguriert ist, eine Position jeder der Treibereinheiten in dem Netzwerk der Treibereinheiten jeder der Treibereinheiten über den Bus mitzuteilen; und
einen Kommunikationskanal (265), der mit jeder der Treibereinheiten gekoppelt ist, wobei die Treibereinheiten dazu konfiguriert sind, über den Kommunikationskanal ohne Vermittlung durch die Systemsteuerung miteinander zu kommunizieren, und jede der Treibereinheiten dazu konfiguriert ist, Fehlerschutzbefehle basierend auf der mitgeteilten Position zu interpretieren.

2. Vorrichtung nach Anspruch 1, wobei jede der Treibereinheiten dazu konfiguriert ist, einen Fehler bei der Ansteuerung ihres jeweiligen Schalters zu charakterisieren und eine Charakterisierung des Fehlers über den Kommunikationskanal auszugeben.

3. Vorrichtung nach Anspruch 2, wobei jede der Treibereinheiten dazu konfiguriert ist, auf entsprechende Charakterisierungen von Fehlern bei der Ansteuerung anderer der Vielzahl von Schaltern anzusprechen, wobei die entsprechenden Charakterisierungen über den Kommunikationskanal empfangen werden.

4. Vorrichtung nach Anspruch 2 oder Anspruch 3, wobei die Vorrichtung ein Wechselrichter ist, und die ausgegebenen Charakterisierungen des Fehlers eine Unterspannungs-Sperrbedingung auf einer primären Seite eines Stromrichters und eine Unterspannungs-Sperrbedingung auf einer sekundären Seite eines Stromrichters umfassen.

5. Vorrichtung nach Anspruch 1, wobei die Systemsteuerung (150) dazu konfiguriert ist, einen Zustand der Vorrichtung jeder der Treibereinheiten über den Bus mitzuteilen.

6. Vorrichtung nach Anspruch 6, wobei jede der Treibereinheiten dazu konfiguriert ist, die Fehlerschutzbefehle basierend auf dem mitgeteilten Zustand der Vorrichtung zu interpretieren.

7. Vorrichtung nach Anspruch 1, wobei die Systemsteuerung ferner mit dem Kommunikationskanal gekoppelt ist.

8. Vorrichtung nach Anspruch 1, wobei der Kommunikationskanal in mindestens einem Draht eines zweiten Busses umgesetzt ist.

9. Vorrichtung nach Anspruch 1, wobei die Vorrichtung einen Wechselrichter (400) umfasst.

10. Vorrichtung nach einem der vorhergehenden Ansprüche, wobei die Positionsinformationen vorgeben, dass eine Gate-Treibereinheit auf einer High-Side oder einer Low-Side in einem Wechselrichter positioniert ist.

11. Vorrichtung nach einem der vorhergehenden Ansprüche, wobei jede der Treibereinheiten (200, 445, 450) dazu geeignet ist, einen Transistor anzusteuern, und umfasst:
eine Kommunikationsschnittstelle, die dazu konfiguriert ist, Zeiteinstellungsinformationen von der Systemsteuerung (150) zu empfangen, die angeben, wann der Transistor (130, 135), der von der Treibereinheit angesteuert wird, umzuschalten ist,
eine erste Klemme (202) und eine zweite Klemme (208), die beide dazu konfiguriert sind, mit der Systemsteuerung (150) gekoppelt zu sein, wobei die erste Klemme dazu konfiguriert ist, die Zeiteinstellungsinformationen zu empfangen, und die zweite Klemme dazu konfiguriert ist, Positionsinformationen zu empfangen, welche die Position der Treibereinheit in dem Netzwerk von Treibereinheiten zu charakterisieren;
Abtastschaltungen (315), die dazu konfiguriert sind, eine oder mehrere Charakteristiken eines Zustands des Transistors, der von der Treibereinheit angesteuert wird, abzutasten; und
Fehlerschutzsteuerschaltungen (320), die mit den Abtastschaltungen gekoppelt sind, und basierend auf der einen oder den mehreren Charakteristiken des Zustands des angesteuerten Transistors dazu konfiguriert sind, einen Fehler bei einer Ansteuerung des angesteuerten Transistors zu kategorisieren, wobei die Fehlerschutzsteuerschaltungen dazu gekoppelt ist, eine Kategorisierung des Fehlers aus der Treibereinheit auszugeben, und wobei die Fehlerschutzsteuerschaltungen ferner dazu konfiguriert sind, entsprechende Kategorisierungen von Fehlern bei der Ansteuerung anderer Transistoren durch andere Treibereinheiten basierend auf den mitgeteilten Positionsinformationen zu interpretieren und darauf anzusprechen.

12. Treibereinheit nach Anspruch 11, wobei die Fehlerschutzsteuerschaltungen dazu gekoppelt sind, die Kategorisierung des Fehlers aus der Treibereinheit über eine Klemme (212) auszugeben und die entsprechenden Kategorisierungen über die gleiche Klemme (212) zu empfangen.

## Revendications

1. Dispositif, comprenant :
une pluralité de commutateurs (130) ;
une pluralité d'unités d'attaque (200, 445, 450), chaque unité d'attaque étant couplée pour commander un commutateur respectif de la pluralité de commutateurs ;
un contrôleur de système (150) couplé à chacune des unités d'attaque par un bus (160), le contrôleur de système étant configuré pour coordonner la commande des commutateurs respectifs par les unités d'attaque pour former un réseau des unités d'attaque qui parvient à une commande souhaitée d'une charge, dans lequel le contrôleur de système est configuré pour communiquer une position de chacune des unités d'attaque dans le réseau des unités d'attaque à chacune des unités d'attaque sur le bus ; et
un canal de communication (265) couplé à chacune des unités d'attaque, les unités d'attaque étant configurées pour communiquer les unes avec les autres sur le canal de communication sans médiation par le contrôleur de système, et chacune des unités d'attaque est configurée pour interpréter des commandes de protection contre les défauts dans la position communiquée.

2. Dispositif selon la revendication 1, dans lequel chacune des unités d'attaque est configurée pour caractériser un défaut de la commande de son commutateur respectif et sortir une caractérisation du défaut sur le canal de communication.

3. Dispositif selon la revendication 2, dans lequel chacune des unités d'attaque est configurée pour répondre à des caractérisations correspondantes de défauts lors de la commande d'autres de la pluralité de commutateurs, les caractérisations correspondantes étant reçues sur le canal de communication.

4. Dispositif selon la revendication 2 ou la revendication 3, dans lequel le dispositif est un onduleur et les caractérisations de sortie du défaut comprennent une condition de blocage de sous-tension d'un côté primaire d'un convertisseur de courant et une condition de blocage de sous-tension d'un côté secondaire d'un convertisseur de courant.

5. Dispositif selon la revendication 1, dans lequel le contrôleur de système (150) est configuré pour communiquer un état du dispositif à chacune des unités d'attaque sur le bus.

6. Dispositif selon la revendication 6, dans lequel chacune des unités d'attaque est configurée pour interpréter les commandes de protection contre les défauts sur la base de l'état communiqué du dispositif.

7. Dispositif selon la revendication 1, dans lequel le contrôleur de système est en outre couplé au canal de communication.

8. Dispositif selon la revendication 1, dans lequel le canal de communication est mis en œuvre dans au moins un fil d'un deuxième bus.

9. Dispositif selon la revendication 1, dans lequel le dispositif comprend un onduleur (400).

10. Dispositif selon l'une quelconque des revendications précédentes, dans lequel les informations de position spécifient qu'une unité d'attaque de grille soit positionnée d'un côté haut ou d'un côté bas dans un onduleur.

11. Dispositif selon l'une quelconque des revendications précédentes, dans lequel chacune des unités d'attaque (200, 445, 450) est adaptée pour commander un transistor et comprend :
une interface de communication configurée pour recevoir des informations de synchronisation de la part du contrôle de système (150) indiquant quand le transistor (130, 135) commandé par l'unité d'attaque doit être commuté ;
une première borne (202) et une deuxième borne (208) toutes les deux configurées pour être couplées au contrôleur de système (150), la première borne étant configurée pour recevoir les informations de synchronisation et la deuxième borne étant configurée pour recevoir des informations de position caractérisant la position de l'unité d'attaque dans le réseau d'unités d'attaque ;
des circuits de détection (315) configurés pour détecter une ou plusieurs caractéristiques d'un état du transistor commandé par l'unité d'attaque ; et
des circuits de commande de protection contre les défauts (320) couplés aux circuits de détection, et sur la base de ladite une ou des plusieurs caractéristiques de l'état du transistor commandé, configurés pour catégoriser un défaut d'une commande du transistor commandé, les circuits de protection contre les défauts étant couplés pour sortir une catégorisation du défaut provenant de l'unité d'attaque, et dans lequel les circuits de commande de protection contre les défauts sont en outre configurés pour interpréter et répondre à des catégorisations correspondantes de défauts lors de la commande d'autres transistors par d'autres unités d'attaque sur la base des informations de position communiquées.

12. Unité d'attaque selon la revendication 11, dans laquelle les circuits de commande de protection contre les défauts sont couplés pour sortir la catégorisation du défaut provenant de l'unité d'attaque par l'intermédiaire d'une borne (212) et pour recevoir des catégorisations correspondantes par l'intermédiaire de la même borne (212).
